# EUROPÄISCHE PATENTSCHRIFT

(11) **EP 2 445 745 B1**
(45) Veröffentlichungstag und Bekanntmachung des Hinweises auf die Patenterteilung: **05.01.2022**
(21) Anmeldenummer: 10725638.0
(22) Anmeldetag: 26.05.2010
(51) Int. Cl.: G01R 21/00, B60L 53/00

(54) **BESTIMMEN VON BEZOGENEN ENERGIEMENGEN**
DETERMINING THE AMOUNT OF ELECTRICITY RECEIVED
DETERMINATION DE QUANTITÉ D'ÉNERGIE RECU

(30) Priorität: 22.06.2009 DE 102009030090
(43) Veröffentlichungstag der Anmeldung: 02.05.2012
(73) Patentinhaber: innogy SE, 45128 Essen (DE)
(72) Erfinder: THEISEN, Thomas, 46286 Dorsten (DE); GAUL, Armin, 59379 Selm (DE); DIEFENBACH, Ingo, 59425 Unna (DE); REHTANZ, Christian, 44227 Dortmund (DE); HORENKAMP, Willi, 44328 Dortmund (DE); ROLINK, Johannes, 48488 Emsbüren (DE)
(74) Vertreter: Patentanwälte Bals & Vogel
(86) Internationale Anmeldenummer: PCT/EP2010/057200
(87) Internationale Veröffentlichungsnummer: WO 2010/149450

(56) Entgegenhaltungen:
- EP-A2- 1 487 079
- WO-A1-96/32768
- WO-A2-2010/074644
- US-A1- 2008 039 980

## Beschreibung

Der Gegenstand betrifft ein Verfahren, ein System sowie eine Vorrichtung zum Bestimmen von Energiemengen, insbesondere zum Bestimmen von durch Elektrofahrzeuge bezogene Energiemengen.

Die Verbreitung elektrisch betriebener Fahrzeuge wird in naher Zukunft rapide zunehmen. Mit der Verbreitung von Elektrofahrzeugen, die mit einem Elektromotor betrieben werden, muss jedoch sichergestellt werden, dass diese in einfachster Weise mit Energie versorgt werden können. Hierzu muss eine funktionierende Infrastruktur zur Verfügung gestellt werden.

Insbesondere muss die Möglichkeit gegeben werden, in öffentlichen Bereichen Energie für Elektrofahrzeuge zu beziehen. Bei den bisher verfügbaren Reichweiten von Elektrofahrzeugen zwischen 50 und einigen 100 km ist es notwendig, dass auch außerhalb des häuslichen Umfeldes ein Laden der Fahrzeuge möglich ist. Hierfür müssen in öffentlichen Bereichen Ladestationen zur Verfügung gestellt werden, um eine stete Verfügbarkeit von Energie für Elektrofahrzeuge durch ein Versorgungsnetz zur Verfügung zu stellen. Diese Verfügbarkeit ist ein entscheidendes Kriterium für die Akzeptanz von Elektrofahrzeugen.

Bei in öffentlichen Bereichen installierten Ladestationen muss jedoch sichergestellt werden, dass der Kunde die bezogene Energie bezahlt. Auch muss sichergestellt werden, dass die Energie die von einem Elektrofahrzeug bezogen wird, nicht demjenigen in Rechnung gestellt wird, der die Ladestation bereithält. Auch im privaten Bereich muss sichergestellt sein, dass die von einem Elektrofahrzeug bezogene Energiemenge nicht durch den Hausbesitzer, bzw. einem Vermieter, welcher die Steckdose zur Verfügung stellt, in Rechnung gestellt wird.

Das Beziehen von elektrischer Energie als auch das Rückspeisen von elektrischer Energie in netzseitige Steckdosen stellt dann ein Problem dar, wenn die Elektrofahrzeuge oder Hybridfahrzeuge an normale Zapfstellen (d.h. Steckdosen einer Ladestation), welche einphasige Haushaltssteckdosen oder dreiphasige Industriesteckdosen sein können, angeschlossen werden. Diese sind mit herkömmlichen Haushalts- oder Industriestromzähler verbunden. In einem solchen Fall ist eine abrechnungstechnische Trennung zwischen der von Fahrzeugen bezogenen Energie und anderweitig bezogener Energie nicht möglich.

Heutige Lösungsansätze gehen davon aus, dass jede einzelne Zapfstelle mit einem separat installierten Energiezähler (Stromzähler) ausgestattet wird. Ein Elektrofahrzeug wird dann an diese Zapfstelle angeschlossen, und eine Abrechnung erfolgt zapfstellenbezogen. Die Zapfstelle muss eine eigene Zähleinrichtung aufweisen sowie eine Logik aufweisen, mit der die Abrechnung des Stroms nutzerbezogen erfolgen kann. Diese Zapfstelle ist jedoch nicht geeignet, um anderweitig bezogenen getrennt von dem von den Elektrofahrzeugen bezogenen Strom abzurechnen.

In diesem Zusammenhang zeigt die US 2009/0062967 A1 ein System sowie eine

Methode zum Laden und Abrechnen von Plug-In Hybridfahrzeugen über Prepaid Nutzer-Konten.

Aus diesem Grunde lag dem Gegenstand die Aufgabe zugrunde, Haushalts- und/oder Industriesteckdosen zum Laden von Elektrofahrzeugen geeignet zu machen, ohne jede Steckdose mit einem separaten Zähler auszustatten. Darüber hinaus war es eine Aufgabe, das Laden von Elektrofahrzeugen an öffentlichen und halböffentlichen Steckdosen zu ermöglichen, ohne dass diese Steckdosen mit gesonderten Zählern ausgestattet werden müssen.

Diese Aufgabe wird durch ein Verfahren zum Bestimmen von Energiemengen gelöst mit den Schritten fahrzeugseitiges Erfassen einer ersten mit einer Zapfstelle ausgetauschten Energiemenge, fahrzeugseitiges Aussenden von Informationen zu der ersten Energiemenge, zapfstellenseitiges einheitliches Erfassen einer Gesamtenergiemenge, gebildet aus der Summe der ersten Energiemenge, sowie einer zweiten, durch die Zapfstelle unabhängig vom Elektrofahrzeug bereitgestellten Energiemenge, und Subtrahieren der von dem Fahrzeug empfangenen ersten Energiemenge von der Gesamtenergiemenge zur Ermittlung der zweiten Energiemenge.

Es ist erkannt worden, dass eine von einem Elektrofahrzeug bezogene Energie nur dann von einer Gesamtenergiemenge abrechnungstechnisch getrennt werden kann, wenn fahrzeugseitig die ausgetauschte Energiemenge erfasst wird.

Dabei kann fahrzeugseitig sowohl eine bezogene Energiemenge als auch eine an das Netz abgegebene Energiemenge als mit einer Zapfstelle ausgetauschte erste Energiemenge erfasst werden. Bezogene Energie kann ein positives Vorzeichen haben, abgegebene Energie kann ein negatives Vorzeichen haben, so dass die Subtraktion der ersten Energiemenge von der Gesamtenergiemenge tatsächlich die zweite Energiemenge ergibt. Bevorzugt ist fahrzeugseitig ein Stromzähler angeordnet, der besonders bevorzugt geeioht ist. Mit Hilfe dieses Stromzählers lässt sich erfassen, wie groß die Energiemenge ist, die mit der Zapfstelle, zum Beispiel einer netzseitigen Steckdose, ausgetauscht wird.

In dem Fahrzeug kann ein programmierter Mikroprozessor angeordnet sein, beispielsweise zu Messzwecken. Die beschriebenen Verfahrensschritte in dem Fahrzeug können durch ein Computerprogramm ausgeführt werden, welches in dem Mikroprozessor des Fahrzeugs implementiert wurde.

Nachdem fahrzeugseitig die ausgetauschte Energiemenge erfasst wurde, wird vom Fahrzeug diese Information ausgesendet. Somit wird außerhalb des Fahrzeugs die in dem Fahrzeug erfasste Energiemenge bekanntgegeben.

Darüber hinaus wird zapfstellenseitig die Gesamtenergiemenge gemessen. Die Gesamtenergiemenge ist die Energiemenge, die über die Zapfstelle abgegeben wurde, abzüglich der ins Netz zurückgespeisten Energie. Die Zapfstelle kann dabei beispielsweise einen Zähler aufweisen, an den zum Einen mehrere Stromsteckdosen zum Aufladen von Elektrofahrzeugen angeschlossen sind und zum Anderen beispielsweise ein Haushaltsstromnetz bzw. ein Industriestromnetz. Der Haushalt- bzw. der Industrieabnehmer bezieht Strom über die Zapfstelle, und gleichzeitig können ein oder mehrere Elektrofahrzeuge über die Zapfstelle Energie beziehen. Die Gesamtenergiemenge setzt sich somit aus allen über einen bestimmten Zähler fließenden Strömen zusammen, unabhängig davon, ob die Energien von Elektrofahrzeugen oder von anderen Verbrauchern bezogen oder gespeist werden. In der Gesamtenergiemenge steckt ein Teil einer durch die Zapfstelle einem Elektrofahrzeug zur Verfügung gestellten ersten Energiemenge und außerdem die von der Zapfstelle unabhängig von dem Elektrofahrzeug bereitgestellte zweite Energiemenge.

Um abrechnungstechnisch die von dem Fahrzeug bezogene Energiemenge von der sonstigen über die Zapfstelle bereitgestellten Energiemenge trennen zu können, wird vorgeschlagen, von dem Wert der Gesamtenergiemenge den Wert der von dem Fahrzeug empfangenen ersten Energiemenge abzuziehen. Wird von dem Wert der Gesamtenergiemenge der Wert der von dem Fahrzeug empfangenen ersten Energiemenge abgezogen, so kann die zweite Energiemenge bzw. der Wert der zweiten Energiemenge errechnet werden. Beispielsweise kann eine Gesamtenergiemenge 10 kWh sein. Die von dem Fahrzeug empfangene erste Energiemenge kann beispielsweise dahingehend sein, dass fahrzeugseitig 7 kWh bezogen wurden. Subtrahiert man nun von den 10 kWh die von dem Fahrzeug bezogenen 7 kWh, so ergibt sich die zweite Energiemenge zu 3 kWh. Somit ist es möglich, die von dem Fahrzeug empfangenen 7 kWh dem Fahrzeug bzw. dem Fahrzeughalter oder einer sonstig dem Fahrzeug zugeordneten Entität in Rechnung zu stellen und die verbleibenden 3 kWh dem Inhabern der Zapfstelle bzw. demjenigen, der für den Bezug der Energie über die Zapfstelle verantwortlich ist, in Rechnung zu stellen.

Durch die gegenständliche Lösung ist eine abrechnungstechnische Trennung zwischen dem von dem Fahrzeug bezogenen Strom und dem sonstig bezogenen Strom möglich. Elektrofahrzeuge können somit an allen verfügbaren Steckdosen geladen werden vorausgesetzt, dass die Steckdose mit einem geeigneten Zähler ausgestattet ist, um die entsprechende Kommunikationsanbindung bereitszutellen. Die Halter der Elektrofahrzeuge müssen sich nicht darum sorgen, dass der Eigentümer bzw. der Betreiber der Steckdose die von ihnen bezogene Energie in Rechnung gestellt bekommt. Vielmehr ist sichergestellt, dass die von den Elektrofahrzeugen bezogene Energie getrennt von der anderweitig bezogenen Energie abgerechnet werden kann.

Es ist bevorzugt, wenn der zapfstellenseitige Zähler ein sogenanntes "Smartmeter" ist, ein solcher Zähler kann fernausgelesen werden. Eine Fernauslesung eines solchen Zählers kann beispielsweise TCP/IP-basiert sein. Ein Fernauslesen des Zählers kann über ein Telefonnetz oder ein Energieversorgungsnetz, beispielsweise mittels Power-Line-Communication, erfolgen.

Um die von dem Fahrzeug erfasste erste Energiemenge mit der dem Fahrzeug zugeordneten Entität, welche für die Abrechnung verantwortlich ist, in Verbindung bringen zu können, ist es im Rahmen einer erfindungsgemäßen Ausführungsform vorgesehen, dass fahrzeugseitig eine das Fahrzeug kennzeichnende Fahrzeugkennung mit der Informationen über die erste Energiemenge ausgesandt wird. Somit kann festgestellt werden, welches Fahrzeug die erste Energiemenge bezogen hat. Mittels der Fahrzeugkennung ist es möglich, die bezogene Energiemenge einem bestimmten Stromtarif zuzuordnen. Beispielsweise ist es möglich, dass für jede Fahrzeugkennung ein bestimmter Energielieferungsvertrag vorliegt, welcher den Preis für die ausgetauschte Energie bestimmt.

Aus datenschutzrechtlichen Gründen kann es möglich sein, die Fahrzeugkennung zu verschlüsseln. Auch kann es möglich sein, dass die Fahrzeugkennung nicht unmittelbar dem Fahrzeug zugeordnet ist, sondern zunächst über temporäre Kennungen und Vertragskennungen verschlüsselt wird, so dass die bezogene Energiemenge nicht unmittelbar dem Fahrzeug, sondern lediglich unmittelbar einem Halter zuordnenbar ist.

Gemäß eines erfindungsgemäßen Ausführungsbeispiels wird vorgeschlagen, dass zapfstellenseitig Informationen zu der ersten Energiemenge zusammen mit der Fahrzeugkennung empfangen werden. Gemäß dieses Ausführungsbeispiels sendet das Fahrzeug die Information zu der bezogenen Energiemenge zusammen mit der Fahrzeugkennung an die Zapfstelle. Eine Kommunikation zwischen Fahrzeug und Zapfstelle kann beispielsweise mittels Power-LinewCommunication erfolgen. Hierbei kann beispielsweise unmittelbar das Ladekabel verwendet werden. Andere Übertragungswege, beispielsweise drahtlose Übertragungswege zwischen Fahrzeug und Zapfstelle, beispielsweise mittels Neaeield-Communication (NFC), WLAN, ZigBee, Bluetooth oder drahtgebundene Kommunikation mittels eines Kommunikationskabels ist hierbei möglich. Die Kommunikation kann TCP/IP basiert sein. Andere paketvermittelte oder leitungsvermittelte Protokolle sind ebenfalls möglich. Die Kommunikation kann über das Ladekabel selbst als auch getrennt von dem Ladekabel erfolgen.

In der Zapfstelle wird gemäß einer erfindungsgemäßen Ausführungsform die Information zu der ersten Energiemenge zusammen mit der Fahrzeugkennung empfangen werden, so dass diese beiden Werte einander zugeordnet weiterverarbeitet können.

Wird in der Zapfstelle die erste Energiemenge zusammen mit der Fahrzeugkennung empfangen, so ist erfindungsgemäß vorgesehen, dass in der Zapfstelle der Wert der von dem Fahrzeug empfangenen ersten Energiemenge von dem Wert der Gesamtenergiemenge subtrahiert wird. Dies ermöglicht es, die zweite Energiemenge zu ermitteln. Wie eingangs erläutert, wird zapfstellenseitig einheitlich die Gesamtenergiemenge erfasst, ohne dass zapfstellenseitig bei dieser Erfassung die erste von der zweiten Energiemenge unterscheidbar ist. Durch das Subtrahieren des Wertes der von dem Fahrzeug empfangenen Information zur ersten Energiemenge von dem Wert der Gesamtenergiemenge ist es möglich, in der Zapfstelle die zweite Energiemenge zu bestimmen. Hierzu kann in der Zapfstelle beispielsweise ein Mikroprozessor angeordnet sein.

In der Zapfstelle kann ein Computerprogramm geladen sein, welches zur Ausführung der Operationen, welche im Zusammenhang mit der Zapfstelle erwähnt werden, programmiert ist.

Gemäß eines erfindungsgemäßen Ausführungsbeispiels wird vorgeschlagen, dass zapfstellenseitig Informationen zu der zweiten Energiemenge zusammen mit einer Zapfstellenkennung ausgesendet werden. Auch ist es im Rahmen einer erfindungsgemäßen Ausführungsform vorgesehen, dass zapfstellenseitig Informationen zu der ersten Energiemenge zusammen mit der zapfstellenseitig empfangenen Fahrzeugkennung ausgesendet werden. Dieses Aussenden kann beispielsweise über die Energieversorgungsleitungen des Energieversorgungsnetzes erfolgen. Auch ist es möglich, dass dieses Aussenden über (weitere) drahtgebundene oder auch drahtlose Weitverkehrsnetze erfolgt. Dabei kann beispielsweise ein Mobilfunknetz, beispielsweise ein GSM, UMTS, LTE Netz verwendet werden. Auch ist es möglich, dass das Aussenden über ein sonstiges Kommunikationsnetz erfolgt. Ein sonstiger Funkstandard, beispielsweise WLAN, kann ebenfalls verwendet werden. In der zapfstelle ist zum Einen die Fahrzeugkennung und die erste Energiemenge bekannt. Diese Information kann zu Abrechnungszwecken verwendet werden, um die von dem Fahrzeug bezogene Energie in Rechnung stellen zu können. Darüber hinaus kann in der Zapfstelle die zweite Energiemenge berechnet worden sein, welche zusammen mit der Zapfstellenkennung dazu verwendet werden kann, die sonstig bezogene Energie dem Inhaber/Betreiber der Zapfstelle in Rechnung zu stellen.

Es wird auch vorgeschlagen, dass Informationen zu der zweiten Energiemenge zusammen mit der Zapfstellenkennung und Informationen zu der ersten Energiemenge zusammen mit der Fahrzeugkennung in einem zentralen Rechner empfangen werden. Der Zentralrechner kann beispielsweise ein Abrechnungszentrum sein.

In dem zentralen Rechner kann beispielsweise ein programmierter Mikroprozessor angeordnet sein. Die in dem zentralen Rechner ablaufenden Verfahrensschritte können durch ein Computerprogramm ausgeführt werden, welches in den Mikroprozessor des zentralen Rechners einprogrammiert wurde.

Der zentrale Rechner kann Kommunikationsmittel enthalten, die die von der Zapfstelle ausgesendeten Informationen empfangen können. Hierbei kann der zentrale Rechner dieselben Kommunikationsprotokolle unterstützen wie die Zapfstelle, so dass eine reibungslose Kommunikation erfolgen kann.

Nachdem in dem zentralen Rechner die Informationen zu der zweiten Energiemenge zusammen mit der Zapfstellenkennung und die Informationen zu der ersten Energiemenge zusammen mit der Fahrzeugkennung empfangen wurden, kann eine Abrechnung erfolgen. Hierzu wird in dem zentralen Rechner zumindest ein erster Datensatz umfassend Informationen über die zweite Energiemenge und eine Zapfstellenkennung erstellt. Darüber hinaus kann zumindest ein zweiter Datensatz umfassend Informationen über die erste Energiemenge sowie die Fahrzeugkennung erstellt werden.

Mittels des ersten Datensatzes ist es möglich, die anderweitig bezogene Energie dem Inhaber der Zapfstelle in Rechnung zu stellen. Dies kann beispielsweise gemäß eines ersten Stromtarifs erfolgen. Die erste Energiemenge kann dem Fahrzeughaltar bzw. demjenigen, der für die Abrechnung der von dem Fahrzeug bezogenen Energie verantwortlich ist, über den zweiten Datensatz in Rechnung gestellt werden. Der erste Datensatz bildet somit die Grundlage für die Abrechnung der sonstig bezogenen Energie, und der zweite Datensatz bildet die Grundlage für die Abrechnung der von dem Fahrzeug bezogenen Energie.

Gemäß eines weiteren erfindungsgemäßen Ausführungsbeispiels ist es vorgesehen, dass fahrzeugseitig eine von der Zapfstelle ausgesendete Zapfstellenkennung empfangen wird. Hierbei kann beispielsweise über das Ladekabel, welches das Fahrzeug mit der Zapfstelle verbindet, diese Information ausgetauscht werden. Auch kann eine separate Kommunikationsleitung verwendet werden, um diese Information auszutauschen. Darüber hinaus kann beispielsweise eine Nahfeldkommunikation (NFC) oder eine sonstige oben genannte Kommunikationsstrecke undein sonstiges oben genanntes Kommunikationsprotokoll zwischen Fahrzeug und Zapfstelle verwendet werden.

Auch kann mittels eines RFID«Lesegeräts in dem Fahrzeug die in der Zapfstelle gespeicherte Zapfstellenkennung ausgelesen werden.

Die Zapfstellenkennung kann auch verschlüsselt übertragen werden.

Nachdem in dem Fahrzeug die Zapfstellenkennung empfangen wurde, ist es vorgesehen, dass fahrzeugseitig Informationen zu der ersten Energiemenge zusammen mit einer Zapfstellenkennung und einer Fahrzeugkennung ausgesendet werden. Dieses Aussenden kann beispielsweise über ein Mobilfunknetz erfolgen. Andere Funktechnologien sind ebenfalls möglich. Auch kann dieses Aussenden über das Ladekabel, welches mit der Zapfstelle und daran anschließend mit einem Energieversorgungsnetz verbunden ist, erfolgen.

Die von dem Fahrzeug ausgesendeten Informationen können gemäß eines vorteilhaften Ausführungsbeispiels in einem zentral angeordneten Rechner empfangen werden. Der zentral angeordnete Rechner kann beispielsweise in dem Energieversorgungsnetz angeordnet sein. Auch ist es möglich, dass der zentral angeordnete Rechner ein außerhalb des Energieversorgungsnetzes angeordneter Rechner ist, der für die Abrechnung der fahrzeugrelevanten Energiemengen eingerichtet ist. In diesem zentral angeordneten Rechner kann die Information zu der ersten Energiemenge zusammen mit der Zapfstellenkennung und der Fahrzeugkennung empfangen werden.

In dem zentral angeordneten Rechner ist es somit möglich, dass zumindest die erste Energiemenge mit Hilfe der empfangenen Fahrzeugkennung einem Fahrzeughalter bzw. einem bestimmten Energieliefervertrag für Energie für Elektromobile zugeordnet wird.

Gemäß eines erfindungsgemäßen Ausführungsbeispiels ist es vorgesehen, dass zapfstellenseitig Informationen zu der Gesamtenergiemenge zusammen mit einer Zapfstellenkennung ausgesendet werden. Dies kann beispielsweise über Power-Line-Communication über das Energieversorgungsnetz erfolgen, so dass ein in dem Energieversorgungsnetz angeordneter Rechner diese Information empfangen kann. Auch ist eine Kommunikation über ein Funknetz oder ein Mobilfunknetz, als auch ein drahtgebundenes Telekommunikationsnetz möglich.

Gemäß eines vorteilhaften Ausführungsbeispiels wird vorgeschlagen, dass Informationen zu der Gesamtenergiemenge zusammen mit der Zapfstellenkennung in einem zentral angeordneten Rechner empfangen werden. Dieser zentral angeordnete Rechner kann von dem zuvor beschriebenen zentral angeordneten Rechner, welcher Informationen zu der ersten Energiemenge zusammen mit der Zapfstellenkennung und der Fahrzeugkennung empfängt, verschieden sein. Auch können diese beiden zentralen Rechner in einer Einheit angeordnet sein. Die von der Zapfstelle ausgesendeten Informationen zu der Gesamtenergiemenge zusammen mit der Zapfstellenkennung können netzseitig empfangen werden.

Netzseitig sind somit zumindest Informationen zu der Gesamtenergiemenge und der Zapfstellenkennung als erste Information und Informationen zu der ersten Energiemenge, zusammen mit der Zapfstellenkennung und der Fahrzeugkennung als zweite Information bekannt. Durch Austausch der ersten und der zweiten Information zwischen den zwei zentral angeordneten Rechnern oder innerhalb des zentral angeordneten Rechners und durch Vergleichen der Zapfstellenkennungen in der ersten Information und der zweiten Information ist es möglich, dass die Gesamtenergiemenge einer bestimmten Zapfstelle einer ersten Energiemenge dieser Zapfstelle zugeordnet wird. Dies bedeutet, dass es mittels der Zapfstellenkennung möglich ist, zunächst die erste Energiemenge herauszufinden, welche von der identifizierten Zapfstelle bezogen wurde. Darüber hinaus kann herausgefunden werden, welche Gesamtenergiemenge von dieser Zapfstelle bezogen wurde und der zuvor ermittelten ersten Energiemenge zugeordnet werden.

Mittels dieser Zuordnung der Zapfstellenkennung zu der Gesamtenergiemenge als auch der ersten Energiemenge ist es netzseitig möglich, den Wert der von dem Fahrzeug empfangenen ersten Energiemenge von dem Wert der empfangenen Gesamtenergiemenge zu subtrahieren und somit netzseitig in einem zentral angeordneten Rechner die zweite Energiemenge zu berechnen.

Nachdem die zweite Energiemenge netzseitig berechnet wurde und einer Zapfstellenkennung zuordnenbar ist, kann gemäß eines vorteilhaften Ausführungsbeispiels ein erster Datensatz umfassend Informationen über die zweite Energiemenge und die Zapfstellenkennung erstellt werden. Dieser erste Datensatz kann zur Abrechnung der sonstig bezogenen Energie über die Zapfstelle verwendet werden. Darüber hinaus kann ein zweiter Datensatz erstellt werden, der Informationen über die erste Energiemenge sowie die Fahrzeugkennung enthält. Dieser zweite Datensatz kann zur Abrechnung der von dem Fahrzeug bezogenen Energie verwendet werden.

Ein weiterer Gegenstand ist ein System zum Bestimmen von Energiemengen mit einem fahrzeugseitigen ersten Zählmittel zum Erfassen einer ersten mit einer energieversorgungsnetzseitigen Zapfstelle ausgetauschten Energiemenge, fahrzeugseitigen Sendemitteln zum Aussenden von Informationen zu der ersten Energiemenge, einem zapfstellenseitigen zweiten Zählmittel zum einheitlichen Erfassen einer Gesamtenergiemenge, gebildet aus der Summe der ersten Energiemenge sowie einer zweiten, durch die Zapfstelle unabhängig vom Elektrofahrzeug bereitgestellten Energiemenge, und Rechenmitteln zum Subtrahieren der von dem Fahrzeug empfangenen ersten Energiemenge von der Gesamtenergiemenge zur Ermittlung der zweiten Energiemenge.

Mittels dieses Systems ist es möglich, verrechnungstechnisch den Fahrzeugstrom von dem sonstigen Strom zu separieren.

Gemäß eines vorteilhaften Ausführungsbeispiels ist das erste Zählmittel geeicht. Insbesondere ist das erste Zählmittel ein geeichter Stromzähler. Der Stromzähler kann fernauslesbar sein. Der Stromzähler kann in dem Fahrzeug angeordnet sein und mit Kommunikationsmitteln in dem Fahrzeug kommunizieren oder Kommunikationsmittel aufweisen. Der Stromzähler kann eine Fahrzeugkennung aufweisen. Auch kann der Stromzähler eine Fahrzeugkennung von dem Fahrzeug auslesen. Die Fahrzeugkennung wird zusammen mit der ersten gemessenen Energiemenge versendet werden. Hierzu kann das erste Zählmittel den Wert der ersten Energiemenge zusammen mit der Fahrzeugkennung in einem Datensatz kombinieren und versenden oder über das Kommunikationsmittel des Fahrzeugs versenden.

Gemäß eines vorteilhaften Ausführungsbeispiels wird vorgeschlagen, dass das zweite Zählmittel zum Fernauslesen einer Zapfstellenkennung sowie einer Gesamtenergiemenge geeignet ist. Hierbei kann das Auslesen beispielsweise über das Energieversorgungsnetz selbst erfolgen. Auch kann eine getrennte Kommunikationsleitung vorgesehen sein. Auch ist es möglich, dass das Auslesen über ein Mobilfunknetz oder ein Telekommunikationsnetz erfolgt.

Erfindungsgemäß ist das Rechenmittel entweder in einer Zapfstelle oder in einem zentral angeordneten Rechner angeordnet.

Ein weiterer Gegenstand ist eine Vorrichtung umfassend Empfangsmittel eingerichtet zum Empfangen von Informationen zu einer ersten Energiemenge zusammen mit einer Fahrzeugkennung, sowie einer Zapfstellenkennung zusammen mit Informationen zu einer zweiten Energiemenge oder einer Gesamtenergiemenge und Datenverarbeitungsmittel zum Erstellen eines ersten Datensatzes umfassend Informationen über eine zweite Energiemenge und die Zapfstellenkennung sowie eines zweiten Datensatzes umfassend Informationen über die erste Energiemenge sowie die Fahrzeugkennung. Diese Vorrichtung kann beispielsweise im zentralen Rechner angeordnet sein oder den zentralen Rechner bilden.

Um aus der Gesamtenergiemenge die zweite Energiemenge bestimmen zu können, wird vorgeschlagen, dass die Vorrichtung Rechenmittel Zum Subtrahieren der von dem Fahrzeug empfangenen ersten Energiemenge von der Gesamtenergiemenge aufweist.

Nachfolgend wird der Gegenstand anhand einer Ausführungsbeispiele zeigenden Zeichnung näher erläutert. In der Zeichnung zeigen:
Fig. 1 den schematischen Aufbau gemäß eines ersten Ausführungsbeispiels;
Fig. 2 ein Nachrichtendiagramm entsprechend der Nachrichten gemäß des ersten Ausführungsbeispiels;
Fig. 3 schematisch den Aufbau eines zweiten Ausführungsbeispiels;
Fig. 4 ein Nachrichtendiagramm entsprechend der Nachrichten gemäß des zweiten Ausführungsbeispiels.

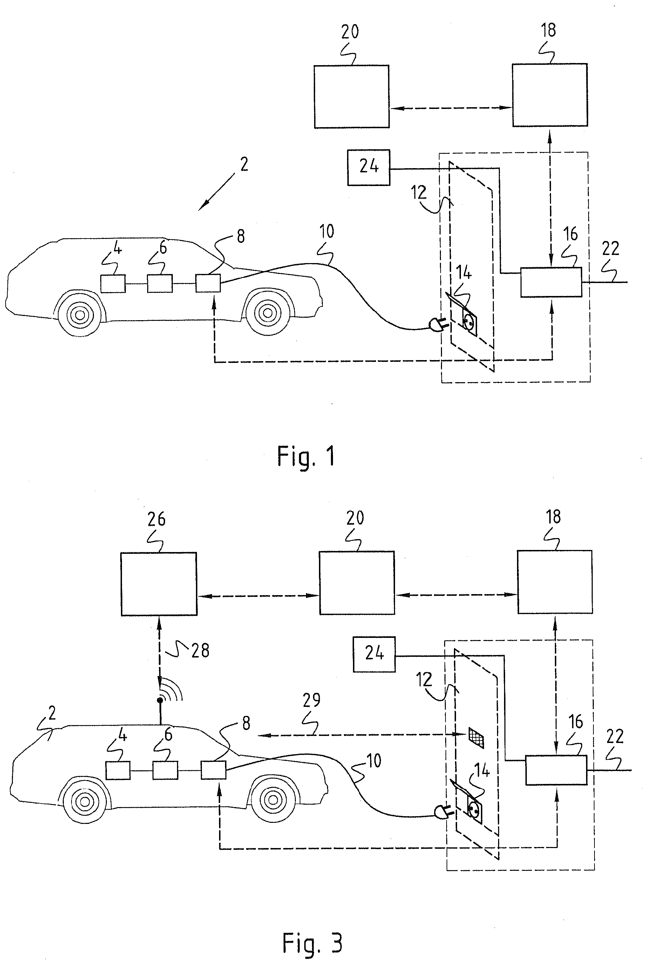

Fig. 1 zeigt ein Fahrzeug 2, welches ein reines Elektrofahrzeug oder ein Hybridfahrzeug sein kann. Das Fahrzeug 2 weist eine Batterie 4 sowie ein Ladesteuergerät 6 auf. Darüber hinaus weist das Fahrzeug 2 einen geeichten Zähler 8 auf. Die Batterie 4 ist über das Ladesteuergerät 6 und den Zähler 8 mittels eines Kabels 10 mit einer Zapfstelle 12 verbunden. Die Zapfstelle 12 weist eine Steckdose 14 sowie einen fernauslesbaren Zähler 16 auf.

Der fernauslesbare Zähler 16 ist über ein Kommunikationsnetz 18 mit einer Abrechnungszentrale 20 verbunden. Darüber hinaus ist der Zähler 16 mit einem Energieversorgungsnetz 22 verbunden. Das Kommunikationsnetz 18 kann Teil des Energieversorgungsnetzes 22 sein, so dass beispielsweise eine Kommunikation mittels Power-Line-Communication über das Energieversorgungsnetz 22 erfolgen kann. Auch kann das Kommunikationsnetz 18 ein drahtgebundenes oder drahtloses KommunikationSnetz sein. Zur Kommunikation kann beispielsweise ein IP-Protokoll verwendet werden.

Die Fig. 1 zeigt ferner, dass an den Zählern 16 zusätzliche Verbraucher 24 angeschlossen sein können, welche ebenfalls über den Zähler 16 Strom von dem Energieversorgungsnetz 22 beziehen.

Während des Ladens des Fahrzeugs 2 bzw. der Batterie 4 des Fahrzeugs 2 über das Kabel 10 fließt Strom von dem Energieversorgungsnetz 22 über den Zähler 16 und die Steckdose 14 sowie das Kabel 10, den Zähler 8 und das Ladegerät 6 in die Batterie 4. Während des Zurückladens bzw. Abgebens eines Stroms von dem Fahrzeugs 2 bzw. der Batterie 4 in des Energieversorgungsnetz 22 fließt über das Kabel 10, die Steckdose 14, den Zähler 16 in das Energieversorgungsnetz 22. Die Summe aus bezogener und abgegebener Energie kann die ausgetauschte Energiemenge darstellen.

Der Zähler 8 zählt den mit der Batterie ausgetauschten Strom bzw. die mit der Batterie ausgetauschte Energiemenge. Der Zähler 16 zählt nicht nur diese Energiemenge, sondern gleichzeitig dazu die von den Verbrauchern 24 bezogene Energiemenge. Die beiden Energiemengen lassen sich in dem Zähler 16 nicht voneinander trennen, so dass der Zähler 16 eine Gesamtenergiemenge ermittelt.

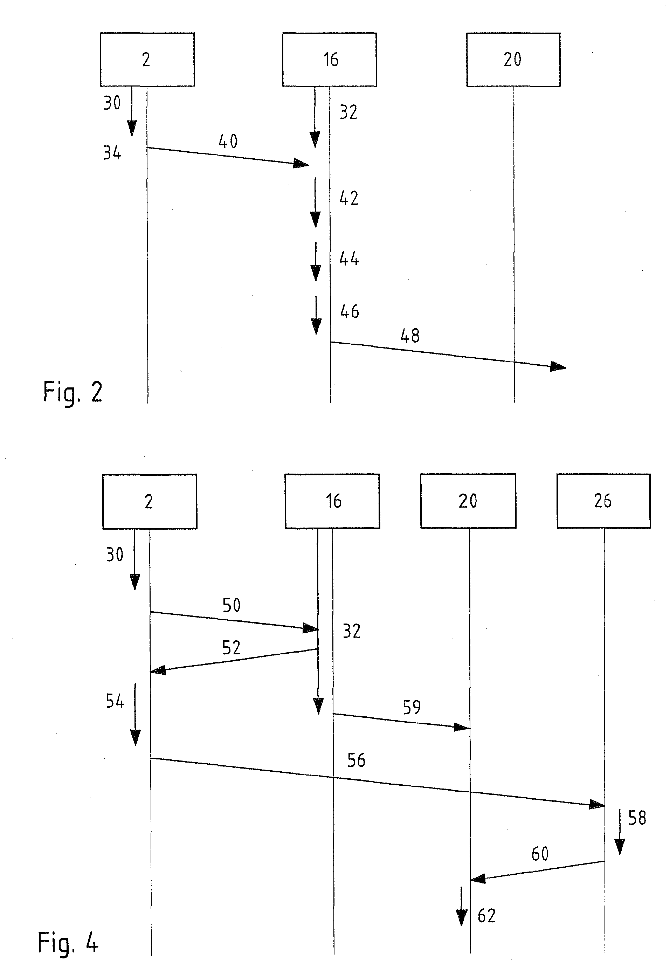

Fig. 2 zeigt den Ablauf des gegenständlichen Verfahrens in einem Nachrichtendiagramm. In Fig. 2 sind das Fahrzeug 2, der Zähler 16 und die Abrechnungszentrale 20 als Blöcke dargestellt. Linien zwischen diesen Blöcken stellen die Kommunikation zwischen den jeweiligen Einheiten dar.

In einem ersten Schritt (30) wird in dem Fahrzeug 2 Energie bezogen und mittels des Zählers 8 die erste Energiemenge erfasst. Parallel dazu wird in einem Schritt (32) in dem Zähler 16 eine Gesamtenergiemenge erfasst, welche die von den Verbrauchern 24 bezogene Energie plus die von dem Fahrzeug 2 bezogene Energie umfasst.

Nach Abschluss eines Ladevorgangs (34) liest der Zähler 8 von dem Ladegerät 6 oder einer sonstigen Einheit innerhalb des Fahrzeugs 2 eine Fahrzeugkennung aus und kombiniert diese in ein erstes Datenpaket, welches an den Zähler 16 übermittelt (40) wird. Es ist auch möglich, dass nicht lediglich zum Ende eines Ladevorgangs 34 ein solches Datenpaket von Fahrzeug 2 bzw. Zähler 8 an den Zähler 16 übermittelt (40) wird, sondern diese Kommunikation kann laufend erfolgen.

In dem Datenpaket ist die erste Energiemenge und die Fahrzeugkennung kodiert. Das Datenpaket kann entweder über das Kabel 10 oder über ein getrenntes Kommunikationskabel an den Zähler 16 übertragen (40) werden. Auch kann eine drahtlose Übertragung (40), beispielsweise mittels Near-Field-Communication (NFC), RFID, WLAN, ZigBee, Bluetooth, Infrarot oder sonstiger Übertragungsmethoden erfolgen.

In dem Zähler 16 ist durch den Empfang des ersten Datenpakets der Wert der ersten Energiemenge zusammen mit der Fahrzeugkennung bekannt. Darüber hinaus ist der in Schritt (32) gemessene Wert der Gesamtenergiemenge bekannt.

In dem Zähler 16 wird von der Gesamtenergiemenge die erste Energiemenge abgezogen (42). Somit wird die zweite Energiemenge ermittelt, welche die Differenz aus der Gesamtenergiemenge und der ersten Energiemenge ist und den Wert der Energie darstellt, welche von dem Verbraucher 24 über den Zähler 16 bezogen wurde.

In dem Zähler 16 bzw. in der Zapfstelle 12, beispielsweise in einem Mikrocomputer, wird nun ein zweites Datenpaket umfassend die Fahrzeugkennung und den Wert der ersten Energiemenge erstellt (44). Darüber hinaus wird ein drittes Datenpaket erstellt (46), welches den Wert der errechneten zweiten Energiemenge als auch eine Zapfstellenkennung enthält. Die Zapfstellenkennung kann beispielsweise in dem Zähler 16 gespeichert sein oder in einem sonstigen Speicher innerhalb der Zapfstelle 12.

Das zweite und das dritte Datenpaket wird an die Abrechnungszentrale 20 über das Kommunikationsnetz 18 in übertragen (48). In der Abrechnungszentrale 20 kann das zweite Datenpaket zur Abrechnung der von dem Fahrzeug bezogenen Energiemenge verwendet werden und das dritte Datenpaket zur Abrechnung des Haushalts- bzw. Industriestroms, welcher durch die Verbraucher 24 bezogen wurde.

Es wurde erläutert, dass in den Schritten (42) und (44) zwei Datenpakete erstellt wurden. Auch ist es möglich, dass diese Schritte (42) und (44) entfallen und dass in dem Schritt 48 der Wert der ersten Energiemenge, die Fahrzeugkennung, der Wert der zweiten Energiemenge und die Zapfstellenkennung übertragen werden und in der Abrechnungszentrale 20 hieraus die zwei Datenpakete errechnet und erstellt werden.

Fig. 3 zeigt ein System gemäß eines zweiten Ausführungsbeispiels. Ergänzend zu dem in Fig. 1 gezeigten Ausführungsbeispiel ist hier eine Kommunikationsstrecke 28 zwischen Fahrzeug 2 und einer Abrechnungszentrale 26 dargestellt. Diese Kommunikationsstrecke 28 kann beispielsweise drahtlos sein und beispielsweise ein Mobilfunkprotokoll verWenden. Außerdem ist eine Kommunikationsstrecke 29 zwischen Fahrzeug 2 und Zapfstelle 12 zum Austausch einer Zapfstellenkennung gezeigt. Diese Kommunikationsstrecke 29 kann drahtlos sein und einen der oben genannten drahtlosen Kommunikationswege verwenden.

Der Ablauf des Verfahrens gemäß des zweiten Ausführungsbeispiels wird nachfolgend in Fig. 4 dargestellt.

Zunächst wird in einem ersten Schritt (30) in dem Fahrzeug 2 mittels des Zählers 8 die erste Energiemenge gemessen. Zum Abschluss eines Ladevorgangs, oder während des Ladevorgangs, oder zu Beginn eines Ladevorgangs fragt das Fahrzeug 2 die Zapfstelle 12 bzw. den Zähler 16 nach einer Zapfstellenkennung ab (50). Die Zapfstelle 12 bzw. der Zähler 16 übermittelt (52) diese Zapfstellenkennung an das Fahrzeug 2. Parallel dazu misst die Zapfstelle 12 einen Gesamtstrom in dem Zähler 16.

In dem Fahrzeug 2 wird die Zapfstellenkennung empfangen, und es wird ein Datenpaket erstellt (54), welches die Zapfstellenkennung, die Fahrzeugkennung und Informationen zu der ersten Energiemenge enthält. Das Fahrzeug übermittelt (56) dieses Datenpaket über die Kommunikationsstrecke 28 an die Abrechnungszentrale 26. In der Abrechnungszentrale 26 wird aus dem Datenpaket die Fahrzeugkennung und die erste Energiemenge extrahiert, und es wird ein weiterer Datensatz erstellt (58), welcher zur Abrechnung der von dem Fahrzeug bezogenen Energie verwendet werden kann.

Währenddessen oder zu einem späteren oder früheren Zeitpunkt übermittelt (59) die Zapfstelle 12 bzw. der Zähler 16 die gemessene Gesamtenergie zusammen mit einer Zapfstellenkennung an die Abrechnungszentrale 20. Dies kann beispielsweise nach Beendigung des Ladevorgangs erfolgen, beispielsweise wenn das Kabel 10 aus dem Stecker 14 entfernt wurde.

Die Abrechnungszentrale 26 übermittelt (60) den Wert der ersten Energiemenge zusammen mit der Zapfstellenkennung, welche im Schritt (56) von dem Fahrzeug 2 empfangen wurde, ebenfalls an die Abrechnungszentrale 20. Somit sind in der Abrechnungszentrale 20 für einen bestimmten Ladevorgang die Gesamtenergiemenge und die Zapfstellenkennung bekannt, welche von dem Zähler 16 empfangen wurde. Darüber hinaus ist die erste Energiemenge, welche von diesem Zähler bezogen wurde, ebenfalls in der Abrechnungszentrale 20 empfangen werden. Somit kann in der Abrechnungszentrale 20 aus der Gesamtenergiemenge, welche einer Zapfstellenkennung zugeordnet ist, und der ersten Energiemenge, welche dieser Zapfstellenkennung ebenfalls zugeordnet ist, die zweite Energiemenge durch Subtraktion der Werte der ersten Energiemenge und der Gesamtenergiemenge errechnen (62) werden. Hiermit kann die Abrechnungszentrale 20 nunmehr ein weiteres Datenpaket erstellen, welches zur Abrechnung der zweiten Energiemenge und somit der von den Verbrauchern 24 bezogenen Energiemenge verwendet werden kann. Dieser Wert der zweiten Energiemenge ist somit frei von durch das Fahrzeug 2 bezogenen Energiemengen.

Mittels des gegenständlichen Verfahrens kann eine Trennung zwischen von Fahrzeugen bezogenen Energiemengen und sonstigen bezogenen Energiemengen erfolgen.

## Patentansprüche

1. Verfahren zum Bestimmen von Energiemengen durch
- fahrzeugseitiges Erfassen (30) einer ersten mit einer Zapfstelle (12) ausgetauschten Energiemenge,
- fahrzeugseitiges Aussenden (40) einer das Fahrzeug (2) kennzeichnenden Fahrzeugkennung,
- fahrzeugseitiges Aussenden (40) von Informationen zu der ersten Energiemenge,
- zapfstellenseitiges einheitliches Erfassen (32) einer Gesamtenergiemenge gebildet aus der Summe der ersten Energiemenge sowie einer zweiten, durch die Zapfstelle (12) unabhängig vom Elektrofahrzeug (2) bereitgestellten Energiemenge,
- zapfstellenseitiges Empfangen der Informationen zu der ersten Energiemenge zusammen mit der Fahrzeugkennung,
- zapfstellenseitiges Subtrahieren (42) der von dem Fahrzeug (2) empfangenen ersten Energiemenge von der Gesamtenergiemenge zur Ermittlung der zweiten Energiemenge,
- zapfstellenseitiges Aussenden (48) von Informationen zu der zweiten Energiemenge zusammen mit einer Zapfstellenkennung und von Informationen zu der ersten Energiemenge zusammen mit der zapfstellenseitig empfangenen Fahrzeugkennung.

2. Verfahren zum Bestimmen von Energiemengen durch
- fahrzeugseitiges Erfassen (30) einer ersten mit einer Zapfstelle (12) ausgetauschten Energiemenge,
- zapfstellenseitiges einheitliches Erfassen (32) einer Gesamtenergiemenge gebildet aus der Summe der ersten Energiemenge sowie einer zweiten, durch die Zapfstelle (12) unabhängig vom Elektrofahrzeug (2) bereitgestellten Energiemenge,
- fahrzeugseitiges Empfangen einer von der Zapfstelle ausgesendeten (52) Zapfstellenkennung,
- fahrzeugseitiges Aussenden (56) der Informationen zu der ersten Energiemenge zusammen mit der Zapfstellenkennung und einer Fahrzeugkennung,
- zapfstellenseitiges Aussenden (59) von Informationen zu der Gesamtenergiemenge zusammen mit einer Zapfstellenkennung.

3. Verfahren nach Anspruch 1, **gekennzeichnet durch** fahrzeugseitiges Aussenden (40) einer das Fahrzeug (2) kennzeichnenden Fahrzeugkennung zusammen mit Informationen zu der ersten Energiemenge.

4. Verfahren nach Anspruch 1, **gekennzeichnet durch** Empfangen der Informationen zu der zweiten Energiemenge zusammen mit der Zapfstellenkennung und der Informationen zu der ersten Energiemenge zusammen mit der Fahrzeugkennung in einem zentralen Rechner (20).

5. Verfahren nach Anspruch 4, **gekennzeichnet durch** Erstellen eines ersten Datensatzes umfassend Informationen über die zweite Energiemenge und eine Zapfstellenkennung sowie eines zweiten Datensatzes umfassend Informationen über die erste Energiemenge sowie die Fahrzeugkennung in dem zentral angeordneten Rechner (20).

6. Verfahren nach Anspruch 2, **gekennzeichnet durch** Empfangen von Informationen zu der ersten Energiemenge zusammen mit der Zapfstellenkennung und der Fahrzeugkennung in einem zentral angeordneten Rechner (26).

7. Verfahren nach Anspruch 2, **gekennzeichnet durch** Empfangen der Informationen zu der Gesamtenergiemenge zusammen mit der Zapfstellenkennung in einem zentral angeordneten Rechner (20).

8. Verfahren nach Anspruch 6 und 7, **gekennzeichnet durch** Subtrahieren (62) der von dem Fahrzeug (2) empfangenen ersten Energiemenge von der empfangenen Gesamtenergiemenge zur Ermittlung der zweiten Energiemenge in dem zentral angeordneten Rechner (20).

9. Verfahren nach Anspruch 8, **gekennzeichnet durch** Erstellen eines ersten Datensatzes umfassend Informationen über die zweite Energiemenge und die Zapfstellenkennung sowie eines zweiten Datensatzes umfassend Informationen über die erste Energiemenge sowie die Fahrzeugkennung in dem zentral angeordneten Rechner (20).

10. System zum Bestimmen von Energiemengen mit
- einem fahrzeugseitigen ersten Zählmittel (8) eingerichtet zum Erfassen einer ersten mit einer energieversorgungsnetzseitigen Zapfstelle (12) ausgetauschten Energiemenge,
- fahrzeugseitigen Sendemitteln eingerichtet zum Aussenden von Informationen zu der ersten Energiemenge sowie einer Fahrzeugkennung,
- einem zapfstellenseitigen zweiten Zählmittel (16) eingerichtet zum einheitlichen Erfassen einer Gesamtenergiemenge gebildet aus der Summe der ersten Energiemenge sowie einer zweiten, durch die Zapfstelle (12) unabhängig vom Elektrofahrzeug bereitgestellten Energiemenge,
- in der Zapfstelle (12) angeordnete Rechenmittel eingerichtet zum Subtrahieren der von dem Fahrzeug (2) empfangenen ersten Energiemenge von der Gesamtenergiemenge zur Ermittlung der zweiten Energiemenge,
wobei die Zapfstelle (12) derart ausgebildet ist, dass zapfstellenseitig Informationen zu der ersten Energiemenge und der Fahrzeugkennung empfangbar sind sowie Informationen zu der ersten Energiemenge und der Fahrzeugkennung und Informationen zu der zweiten Energiemenge und einer Zapfstellenkennung aussendbar sind.

11. System zum Bestimmen von Energiemengen mit
- einem fahrzeugseitigen ersten Zählmittel (8) eingerichtet zum Erfassen einer ersten mit einer energieversorgungsnetzseitigen Zapfstelle (12) ausgetauschten Energiemenge, fahrzeugseitigen Sendemitteln eingerichtet zum Aussenden von Informationen zu der ersten Energiemenge sowie einer Fahrzeugkennung und einer Zapfstellenkennung,
- einem zapfstellenseitigen zweiten Zählmittel (16) eingerichtet zum einheitlichen Erfassen einer Gesamtenergiemenge gebildet aus der Summe der ersten Energiemenge sowie einer zweiten, durch die Zapfstelle (12) unabhängig vom Elektrofahrzeug bereitgestellten Energiemenge,
- in einem zentral angeordneten Rechner (20) angeordnete Rechenmittel eingerichtet zum Subtrahieren der von dem Fahrzeug (2) empfangenen ersten Energiemenge von der Gesamtenergiemenge zur Ermittlung der zweiten Energiemenge,
wobei die Zapfstelle (12) derart ausgebildet ist, dass zapfstellenseitig Informationen zu der Gesamtenergiemenge und der Zapfstellenkennung aussendbar sind und das Fahrzeug (2) derart ausgebildet ist, dass fahrzeugseitig Informationen zu der Zapfstellenkennung empfangbar sind.

12. System nach Anspruch 11, **dadurch gekennzeichnet, dass** das zweite Zählmittel (16) zum Fernauslesen einer Zapfstellenkennung sowie einer Gesamtenergiemenge geeignet ist.

13. Vorrichtung umfassend
- Empfangsmittel eingerichtet zum Empfangen von Informationen zu einer ersten, fahrzeugseitig erfassten Energiemenge zusammen mit einer Fahrzeugkennung sowie einer Zapfstellenkennung zusammen mit Informationen zu einer zweiten Energiemenge oder einer Gesamtenergiemenge,
- Datenverarbeitungsmittel eingerichtet zum Erstellen eines ersten Datensatzes umfassend eine zweite Energiemenge und die Zapfstellenkennung sowie eines zweiten Datensatzes umfassend die erste Energiemenge sowie die Fahrzeugkennung,
- Rechenmittel eingerichtet zum Subtrahieren der von dem Fahrzeug empfangenen ersten Energiemenge von der Gesamtenergiemenge zur Ermittlung der zweiten Energiemenge.

## Claims

1. Method for determining energy quantities by
- detecting (30), on the vehicle side, of a first energy quantity exchanged with a dispensing point (12),
- transmitting (40), on the vehicle side, of a vehicle identifier identifying the vehicle (2),
- transmitting (40), on the vehicle side, information about the first energy quantity,
- uniformly detecting (32), at the dispensing point, a total energy quantity formed from the sum of the first energy quantity and a second energy quantity provided by the dispensing point (12) independently of the electric vehicle (2),
- receiving, at the dispensing point, the information on the first energy quantity together with the vehicle identifier,
- subtracting (42), at the dispensing point, the first energy quantity received from the vehicle (2) from the total energy quantity to determine the second energy quantity,
- transmitting (48), at the dispensing point, information relating to the second energy quantity together with a dispensing point identifier and information relating to the first energy quantity together with the vehicle identifier received at the dispensing point.

2. Method for determining energy quantities by
- detecting (30), on the vehicle side, of a first energy quantity exchanged with a dispensing point (12),
- uniformly detecting (32), at the dispensing point, a total energy quantity formed from the sum of the first energy quantity and a second energy quantity provided by the dispensing point (12) independently of the electric vehicle (2),
- receiving, on the vehicle side, of a dispensing point identifier transmitted (52) by the dispensing point,
- transmitting (56), on the vehicle side, the information on the first energy quantity together with the dispensing point identifier and a vehicle identifier,
- transmitting (59), at the dispensing point, of information on the total energy quantity together with a dispensing point identifier.

3. Method according to claim 1, **characterized by** transmitting (40), on the vehicle side, a vehicle identifier identifying the vehicle (2) together with information on the first energy quantity.

4. Method according to claim 1, **characterized by** receiving the information on the second energy quantity together with the dispensing point identifier and the information on the first energy quantity together with the vehicle identifier in a central computer (20).

5. Method according to claim 4, **characterized by** creating, in the central computer (20), a first data set comprising information about the second energy quantity and a dispensing point identifier and a second data set comprising information about the first energy quantity and the vehicle identifier.

6. Method according to claim 2, **characterized by** receiving information on the first energy quantity together with the dispensing point identifier and the vehicle identifier in a central computer (26).

7. Method according to claim 2, **characterized by**
receiving the information on the total energy quantity together with the dispensing point identifier in a central computer (20).

8. Method according to claim 6 and 7, **characterized by**
subtracting (62) the first energy quantity received from the vehicle (2) from the received total energy quantity to determine the second energy quantity in the central computer (20).

9. Method according to claim 8, **characterized by**
creating, in the central computer (20), a first data set comprising information about the second energy quantity and the dispensing point identifier and a second data set comprising information about the first energy quantity and the vehicle identifier.

10. System for determining energy quantities with
- a first counting means (8) on the vehicle side being set up for detecting a first energy quantity exchanged with a dispensing point (12) on the power supply network side,
- transmitting means, on the vehicle side, for transmitting information on the first energy quantity and a vehicle identifier,
- a second counting means (16), at the dispensing point, being set up for uniformly detecting a total energy quantity formed from the sum of the first energy quantity and a second energy quantity provided by the dispensing point (12) independently of the electric vehicle,
- computing means arranged in the dispensing point (12) being arranged to subtract the first energy quantity received from the vehicle (2) from the total energy quantity to determine the second energy quantity,
wherein the dispensing point (12) is designed in such a way that, at the dispensing point, information relating to the first energy quantity and the vehicle identifier can be received and information relating to the first energy quantity and the vehicle identifier and information relating to the second energy quantity and a dispensing point identifier can be transmitted.

11. System for determining energy quantities with
- a first counting means (8), on the vehicle side, being set up for detecting a first energy quantity exchanged with a dispensing point (12) on the power supply network side,
- transmitting means, on the vehicle side, for transmitting information on the first energy quantity as well as a vehicle identifier and a dispensing point identifier,
- a second counting means (16), at the dispensing point, being set up for uniformly detecting a total energy quantity formed from the sum of the first energy quantity and a second energy quantity provided by the dispensing point (12) independently of the electric vehicle,
- computing means arranged in a central computer (20) being arranged to subtract the first energy quantity received from the vehicle (2) from the total energy quantity to determine the second energy quantity,
wherein the dispensing point (12) is designed in such a way that, at the dispensing point, information relating to the total energy quantity and the dispensing point identifier can be transmitted, and the vehicle (2) is designed in such a way that, on the vehicle side, information relating to the dispensing point identified can be received.

12. The system of claim 11, **characterized in that** the second counting means (16) is adapted to remotely read a dispensing point identifier and a total energy quantity.

13. Device comprising
- receiving means arranged to receive information relating to a first energy quantity detected on the vehicle side together with a vehicle identifier and a dispensing point identifier together with information relating to a second energy quantity or a total energy quantity,
- a data processing means arranged to create a first data set comprising a second energy quantity and the dispensing point identifier and a second data set comprising the first energy quantity and the vehicle identifier,
- computing means arranged to subtract the first energy quantity received from the vehicle from the total energy quantity to determine the second energy quantity.

## Revendications

1. Procédé pour déterminer les quantités d'énergie par
- détection embarquée (30) d'une première quantité d'énergie échangée avec un distributeur (12),
- transmission embarquée (40) d'une identifiant du véhicule identifiant le véhicule (2),
- transmission embarquée (40) des informations sur la première quantité d'énergie,
- détection uniforme (32), du côté du distributeur, d'une quantité d'énergie totale formée à partir de la somme de la première quantité d'énergie et d'une deuxième quantité d'énergie fournie par le distributeur (12) indépendamment du véhicule électrique (2),
- réception, du côté du distributeur, des informations sur la première quantité d'énergie ainsi que l'identifiant du véhicule,
- soustraire (42), du côté du distributeur, la première quantité d'énergie reçue du véhicule (2) de la quantité totale d'énergie pour déterminer la deuxième quantité d'énergie,
- transmission (48), du côté du distributeur, des informations sur la deuxième quantité d'énergie avec un identifiant du distributeur et des informations sur la première quantité d'énergie avec l'identifiant du véhicule reçu du distributeur.

2. Procédé pour déterminer les quantités d'énergie par
- détection embarquée (30) d'une première quantité d'énergie échangée avec un distributeur (12),
- détection uniforme (32), du côté du distributeur, d'une quantité d'énergie totale formée à partir de la somme de la première quantité d'énergie et d'une deuxième quantité d'énergie fournie par le distributeur (12) indépendamment du véhicule électrique (2),
- réception embarquée d'un identifiant du distributeur (52) transmis par le distributeur,
- transmission embarquée (56) des informations sur la première quantité d'énergie ainsi que l'identifiant du distributeur et un identifiant du véhicule,
- transmission (59), du côté du distributeur, des informations sur la quantité totale d'énergie ainsi que d'un identifiant du distributeur.

3. Procédé selon la revendication 1, **caractérisé par** la transmission embarquée (40) d'un identifiant du véhicule identifiant le véhicule (2) ainsi que des informations sur la première quantité d'énergie.

4. Procédé selon la revendication 1, **caractérisé par** la réception des informations sur la deuxième quantité d'énergie avec l'identifiant du distributeur et les informations sur la première quantité d'énergie avec l'identifiant du véhicule dans un ordinateur central (20).

5. Procédé selon la revendication 4, **caractérisé par** la création dans l'ordinateur central (20) d'un premier ensemble de données comprenant des informations sur la seconde quantité d'énergie et un identifiant du distributeur et un second ensemble de données comprenant des informations sur la première quantité d'énergie et l'identifiant du véhicule.

6. Procédé selon la revendication 2, **caractérisé par** la réception des informations sur la première quantité d'énergie avec l'identifiant du distributeur et l'identifiant du véhicule dans un ordinateur central (26).

7. Procédé selon la revendication 2, **caractérisé par** la réception des informations sur la quantité totale d'énergie ainsi que l'identifiant du distributeur dans un ordinateur central (20).

8. Procédé selon les revendications 6 et 7, **caractérisé par** la soustraction (62) de la première quantité d'énergie reçue du véhicule (2) de la quantité totale d'énergie reçue pour déterminer la deuxième quantité d'énergie dans l'ordinateur central (20).

9. Procédé selon la revendication 8, **caractérisé par** la création d'un premier ensemble de données comprenant des informations sur la deuxième quantité d'énergie et l'identifiant du distributeur et un deuxième ensemble de données comprenant des informations sur la première quantité d'énergie et l'identifiant du véhicule dans l'ordinateur central (20).

10. Système pour déterminer des quantités d'énergie avec
- un premier moyen de comptage embarquée (8) qui est configuré pour détecter une première quantité d'énergie échangée avec un distributeur (12) du côté du réseau d'alimentation électrique,
- des moyens de transmission embarquée pour la transmission des informations sur la première quantité d'énergie et une identifiant du véhicule,
- un second moyen de comptage (16), du côté du distributeur, qui est mis en place pour la détection uniforme d'une quantité d'énergie totale formée de la somme de la première quantité d'énergie et d'une seconde quantité d'énergie fournie par le distributeur (12) indépendamment du véhicule électrique,
- des moyens de calcul disposés dans le distributeur (12) pour soustraire la première quantité d'énergie reçue du véhicule (2) de la quantité totale d'énergie afin de déterminer la deuxième quantité d'énergie,
dans lequel le distributeur (12) étant conçu de telle sorte que des informations sur la première quantité d'énergie et l'identifiant du véhicule peuvent être reçues du côté du distributeur et que des informations sur la première quantité d'énergie et l'identifiant du véhicule et des informations sur la deuxième quantité d'énergie et une identifiant du distributeur peuvent être transmises.

11. Système pour déterminer des quantités d'énergie avec
- un premier moyen de comptage embarquée (8) qui est configuré pour détecter une première quantité d'énergie échangée avec un distributeur (12) du côté du réseau d'alimentation électrique,
- des moyens de transmission embarquée pour la transmission des informations sur la première quantité d'énergie ainsi qu'un identifiant du véhicule et un identifiant du distributeur,
- un second moyen de comptage (16), du côté du distributeur, qui est mis en place pour la détection uniforme d'une quantité d'énergie totale formée de la somme de la première quantité d'énergie et d'une seconde quantité d'énergie fournie par le distributeur (12) indépendamment du véhicule électrique,
- des moyens de calcul agencés dans un ordinateur central (20) agencé pour soustraire la première quantité d'énergie reçue du véhicule (2) de la quantité totale d'énergie pour déterminer la deuxième quantité d'énergie,
dans lequel le distributeur (12) étant conçu de telle sorte que des informations sur la quantité totale d'énergie et l'identifiant du distributeur peuvent être transmises du côté du distributeur, et le véhicule (2) étant conçu de telle sorte que des informations sur l'identifiant du distributeur peuvent être reçues embarquée.

12. Système selon la revendication 11, **caractérisé en ce que** le second moyen de comptage (16) est adapté pour lire à distance un identifiant du distributeur et une quantité totale d'énergie.

13. Dispositif comprenant
- des moyens de réception agencés pour recevoir des informations sur une première quantité d'énergie détectée embarquée ainsi qu'un identifiant du véhicule et un identifiant du distributeur ainsi que des informations sur une deuxième quantité d'énergie ou une quantité totale d'énergie,
- des moyens de traitement de données agencés pour créer un premier ensemble de données comprenant une seconde quantité d'énergie et l'identifiant du distributeur et un second ensemble de données comprenant la première quantité d'énergie et l'identifiant du véhicule,
- des moyens de calcul agencés pour soustraire la première quantité d'énergie reçue du véhicule de la quantité totale d'énergie pour déterminer la deuxième quantité d'énergie.
